# EUROPÄISCHE PATENTSCHRIFT

(11) **EP 0 347 604 B1**
(45) Veröffentlichungstag und Bekanntmachung des Hinweises auf die Patenterteilung: **11.08.1993**
(21) Anmeldenummer: 89109309.8
(22) Anmeldetag: 24.05.1989
(51) Int. Cl.: H03H 7/48

(54) **Richtkoppler-Abzweiger**
Direction coupler-distributor
Coupleur directionnel-distributeur

(30) Priorität: 24.06.1988 DE 3821365
(43) Veröffentlichungstag der Anmeldung: 27.12.1989
(73) Patentinhaber: RICHARD HIRSCHMANN GMBH & CO., 73726 Esslingen (DE)
(72) Erfinder: Wendel, Wolfgang, D-7316 Köngen (DE); Pasadu, Chaiyakarn, D-7317 Wendlingen (DE); Epple, Ralf, D-7314 Wernau (DE)
(74) Vertreter: Stadler, Heinz, Dipl.-Ing.

(56) Entgegenhaltungen:
- EP-A- 0 044 909
- US-A- 3 537 036
- US-A- 3 716 806

## Beschreibung

Die Erfindung geht aus von einem Richtkoppler-Abzweiger gemäß dem Oberbegriff des Anspruches 1.
Richtkoppler-Abzweiger werden vor allem wegen ihrer hohen Entkopplung des Ausganges vom Abzweiganschluß in großem Umfang in Gemeinschaftsantennen- bzw. BK-Anlagen eingesetzt. Sie sind für Abzweigdämpfungen von ≳ 13 dB mit guten elektrischen Übertragungskennwerten realisierbar. In der Praxis werden jedoch häufig auch geringere Abzweigdämpfungen, letztlich bis herunter zu 3 dB (hochentkoppelter Verteiler) benötigt, insbesondere zum Beispiel für kleinere Verteilnetze ohne Verstärker oder in größeren Anlagen zur Versorgung der letzten Teilnehmer einer längeren Stammleitung mit einem trotz der bereits großen Stammdämpfung ausreichend hohen Signalpegel als Stammleitungsabzweiger oder Abzweiger in Antennensteckdosen.

Geringere Abzweigdämpfungen erfordern jedoch höhere Übertrager-Windungszahlen in der durchgehenden (Stamm-) Leitung, wodurch sich die elektrischen Daten, vor allem im UHF-Bereich derart verschlechtern, daß die praktische Anwendung stark eingeschränkt ist. Für die genannten Zwecke werden daher derzeit als Abzweigschaltungen zumeist asymmetrische Verteiler eingesetzt, die aus einem Anpaß- und einem Differentialübertrager sowie einer Entkopplungsimpedanz bestehen. Mit diesen Schaltungen wird insbesondere zum Beispiel der in der Vorschrift 1 R8-15 der Deutschen Bundespost geforderte Wert für die Entkopplung der Fernsehanschlüsse zweier Antennensteckdosen von ≧40 dB jedoch nur knapp und auch nur bei idealem Abschlußwiderstand in der Stammleitung eingehalten. In realen Verteilnetzen mit zun Beispiel durch Kaskadierung nicht ideal angepaßten Geräten kann dagegen die Entkopplung unter diesen Betrag absinken und auch die Durchgangs- und Rückflußdämpfungen weisen keine optimalen Werte auf.

Aus der DE-C 3028683 (EP-A-0 044 909), Figur 7, ist es bereits grundsätzlich bekannt, durch Kettenschaltung zweier Richtkoppler-Abzweiger und Zusammenschaltung der beiden Abzweiganschlüsse über Selektionsmittel auf einen einzigen Anschluß (entweder FS oder UKW) eine geringere Abzweigdämpfung zu erzielen. Diese Verringerung beträgt jedoch lediglich ca. 2,5 dB und wird auch nur selektiv und mit erheblichem Schaltungsaufwand erreicht.

Es ist daher Aufgabe der Erfindung, einen Richtkoppler-Abzweiger der eingangs genannten Art auf möglichst einfache und kostengünstige Weise so weiterzubilden, daß er möglichst unabhängig von den Anschlußimpedanzen breitbandig eine möglichst geringe Abzweigdämpfung bei kleiner Durchgangsdämpfung, sowie eine hohe Koppeldämpfung zwischen Ausgang und Abzweig und hohe Rückflußdämpfungen an allen Anschlüssen aufweist.

Diese Aufgabe ist durch die im Anspruch 1 angegebenen Merkmale gelöst. Dabei bedeutet "vorfolgend" lediglich, daß die für die Betrachtung einmal gewählte Reihenfolge der Einzelabzweiger gleichbleibt, da nicht zugleich der vor- und der nachfolgende Einzelabzweiger den internen Widerstand eines Einzelabzweigers bilden kann. Es ist jedoch gleichgültig, ob der in diesem Sinne erste Richtkoppler-Einzelabzweiger eingangs- oder ausgangsseitig eingeschaltet ist.

Durch die erfindungsgemäße Zusammenschaltung ist bei Verwendung zweier Richtkoppler-Einzelabzweiger breitbandig über den gesamten VHF/UHF-Bereich eine Verringerung der Abzweigdämpfung um idealerweise 6 dB, in der Praxis typisch ca. 5 dB bei einer hohen, von Fehlanpassungen der Anschlüsse (insbesondere des Eingangs) weitgehend unabhängigen Koppeldämpfung zwischen Ausgang und Abzweig von ≧ 40 dB sowie hohe Rückflußdämpfungen an den Anschlüssen und einer geringen Durchgangsdämpfung (da die Primärwicklung der Stromübertrager trotz der kleinen Abzweigdämpfung nur 0,5 Windungen aufweisen) erreicht. Beispielsweise beträgt die Abzweigdämpfung bei Zusammenschaltung zweier 13-dB-Abzweiger typisch etwa 8 dB, werden 4 derartige Einzelabzweiger erfindungsgemäß zusammengeschaltet, so beträgt die tatsächliche Abzweigdämpfung etwa 3 dB (Verteiler).
Der geschilderte Vorteil erfordert dabei nicht nur keinen Mehraufwand, vielmehr sind sogar noch Bauteile (interne Widerstände) eingespart.
Bei Verwendung dieses Richtkoppler-Abzweigers können zum Beispiel in einer längeren Antennensteckdosenkette die letzten Teilnehmer besser bzw. ohne Verstärker mit Hochfrequenz-Signalenergie versorgt werden. Außerdem sind damit Sternkoppler und Vielfachverteiler mit wesentlich geringerer Anschlußdämpfung realisierbar. Im Vergleich zur Verwendung von Antennensteckdosen mit asymmetrischen Verteilern sind bei Einsatz des erfindungsgemäßen Richtkoppler-Abzweigers erheblich längere Antennensteckdosenketten mit hoher Entkopplung der Teilnehmeranschlüsse möglich.

Im Regelfall besteht der erfindungsgemäße Richtkoppler-Abzweiger gemäß Anspruch 2 aus lauter Richtkoppler-Einzelabzweigern und weist dann die genannten guten elektrischen Daten auf. Im Einzelfall kann jedoch auch die in Anspruch 3 angegebene kostengünstigere Lösung sinnvoll sein, bei der der erste Richtkoppler-Einzelabzweiger durch im einfachsten Fall einen ohmschen Widerstand, in der Regel aber zur Anpassung an die im Einzelfall erwünschte Abzweigdämpfung durch einen Spannungsteiler ersetzt ist, dafür aber eine etwas erhöhte Durchgangsdämpfung und eine geringere Reduzierung der Abzweigdämpfung in Kauf genommen werden muß. Die Widerstände sind dabei so zu wählen, daß die Impedanz am Abzweiganschluß des Widerstandsabzweigers als interner Abschlußwiderstand des nachfolgenden Richtkoppler-Einzelabzweigers wenigstens näherungsweise gleich dem Wellenwiderstand ist. Außerdem muß in analoger Weise zur Ausführung nach Anspruch 2 und der dem Abzweiganschluß des Widerstandsabzweigers entnommene Strom wenigstens annähernd phasengleich mit den aus den Stromübertragern der Richtkoppler-Einzelabzweiger ausgekoppelten Strömen sein.

Durch eine aus der DE-C-3028683 an sich bekannte alternierende Auf- bzw. Abwärtstransformation der Impedanzen aufeinanderfolgender Richtkoppler-Einzelabzweiger gemäß Anspruch 4 ist eine weitere wesentliche Verbesserung von Rückfluß- und Durchgangsdämpfung erzielt und die Kaskadierbarkeit noch erhöht. Werden nur Richtkoppler-Einzelabzweiger verwendet, so kann dabei ebenso mit einem abwärtstransformierenden wie mit einem aufwärtstransformierenden Richtkoppler-Einzelabzweiger begonnen werden (es ist dabei lediglich auf die richtige Auswahl aus den vier möglichen Grundtypen gemäß den Figuren 1 bis 4 der DE-PS 3028683 zu achten), bei einem Richtkoppler-Abzweiger gemäß Anspruch 3 muß der auf den abwärtstransformierenden Widerstandsabzweiger folgende Richtkoppler-Einzelabzweiger vom aufwärtstransformierenden Typ sein.

Eine vorteilhafte Ausbildung der Erfindung gemäß Anspruch 5 besteht weiterhin darin, daß für die Spannungsübertrager wenigstens zweier Richtkoppler-Einzelabzweiger lediglich eine einzige Primärwicklung vorgesehen ist. Durch die Verwendung nur eines Kernes wird die Kettenschaltung im Aufwand noch günstiger. Außerdem sind dadurch auch die Verluste verringert.

Gemäß einer weiteren vorteilhaften Ausgestaltung der Erfindung durchsetzen jeweils zwei Sekundärwicklungen des Spannungsübertragers zumindest mit einem Teil ihrer Windungen den Rohrkern nach Art eines Differentialübertragers gegensinnig. Auf diese einfache Weise werden die Verluste im internen Abschlußwiderstand noch mehr reduziert, so daß die tatsächliche Verminderung der Abzweigdämpfung dem theoretischen Wert von 6 dB weiter angenähert ist.

Eine Ausführung des Spannungsübertragers nach Anspruch 7 bewirkt, daß die niedrige Abzweigdämpfung trotz hoher Entkopplung von Ausgangs- und Abzweiganschluß breitbandig, insbesondere auch zu hohen Frequenzen hin, konstant ist.

Der Einsatz von Bilochkernen in der in Anspruch 8 beschriebenen Weise ergibt eine Reihe von Vorteilen, die den etwas höheren Preis im Vergleich zur Verwendung getrennter Einzellochkerne bei weitem überwiegen:
- Die Phasengleichheit der aus den Stromübertragern ausgekoppelten Ströme ist im Vergleich zum Aufbau aus getrennten Rohrkernen durch die hier kleinen Abmessungen beim Stromübertrager tatsächlich erreicht, so daß die Abzweigdämpfung und die Entkopplung des Ausgangs vom Abzweig auch bei noch kleinerer Abzweigdämpfung von zum Beispiel 5 dB breitbandig (auch bei sehr hohen Frequenzen) konstant ist.
- Durch entsprechende Wahl des (geringen) Lochdurchmessers bzw. der mechanischen Kernabmessungen ergeben sich auch bei Handwicklung äußerst geringe Fertigungstoleranzen, so daß zwangsweise nur äußerst geringe Abweichungen der Kopplungen von den jeweils geforderten Sollwerten. auftreten. Bei Verwendung getrennter Lochkerne ist eine derartige Konstanz, jedenfalls für die mehrere Windungen aufweisenden Sekundärwicklungen nicht gewährleistet.
- Durch die Lochabmessungen bzw. deren Verhältnis zum Drahtdurchmesser ist das jeweils gewünschte Verhältnis der Kopplungen von Strom- zu Spannungsübertragern einfach und kostengünstig realisierbar (Anspruch 5).

Mit einer Ergänzung des erfindungsgemäßen Richtkoppler-Abzweigers nach Anspruch 9 ist auf sehr einfache und kostengünstige Weise eine breitbandige Antennensteckdose für den Rundfunk- und Fernseh-Empfang geschaffen, wobei für eine einwandfreie Anpassung lediglich zum einen die Impedanz des Abzweiganschlusses durch entsprechende Wahl des Windungszahlenverhältnisses der Sekundärwicklungen des Spannungsübertragers auf Z_{L}/2 zu bringen ist und zum anderen die Anschlüsse RF und TV durch das Differential-Übertragerprinzip ausreichend zu entkoppeln sind.

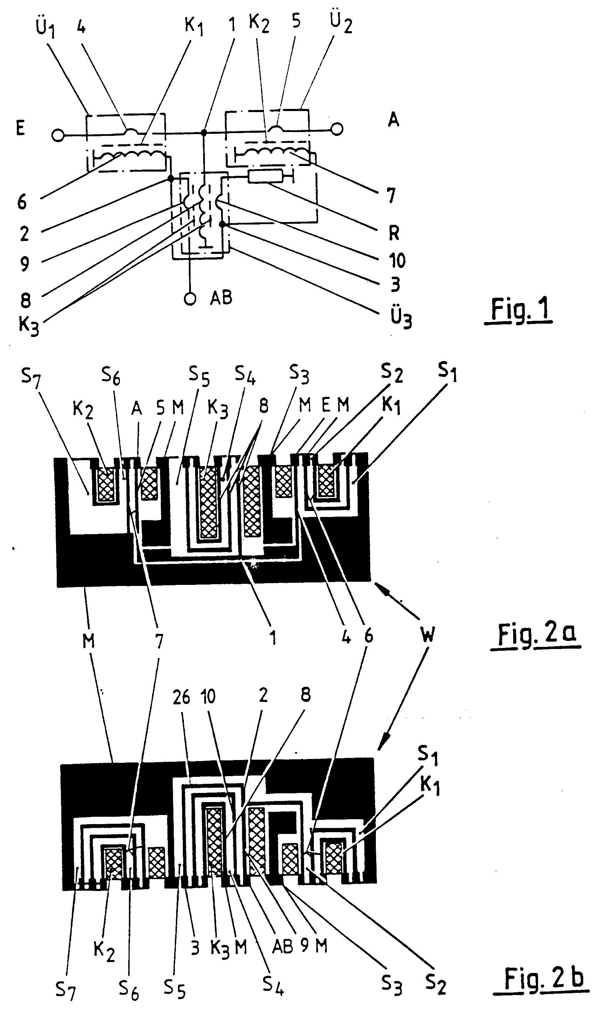

Die Erfindung ist nachfolgend anhand zweier Ausführungsbeispiele näher erläutert, die beide zum Einsatz in Antennensteckdosen für größere Gemeinschaftsantennen- oder BK-Anlagen konzipiert sind. Die erste, in den Figuren 1 bis 3 dargestellte Ausführung ist ein aus der erfindungsgemäßen Zusammenschaltung zweier 13-dB-Richtkoppler-Einzelabzweiger gebildeter, in Drucktechnik aufgebauter 7-dB-Richtkopplerabzweiger für große Stückzahlen mit einer in eine Trägerplatine eingesteckten Übertrager-Wicklungsplatine. Im zweiten Beispiel (Figuren 4 und 5) ist ein für kleinere Stückzahlen mit von Hand gewickelten Übertragern entwickelter 5-dB-Richtkoppler-Abzweiger beschrieben, der um einen symmetrischen Zweifachverteiler erweitert ist.
Dabei zeigen
- Figur 1: ein Prinzipschaltbild des ersten Richtkoppler-Abzweigers,
- Figur 2 a, b: Ansichten der beiden Seiten der zugehörigen Übertrager-Wicklungsplatine

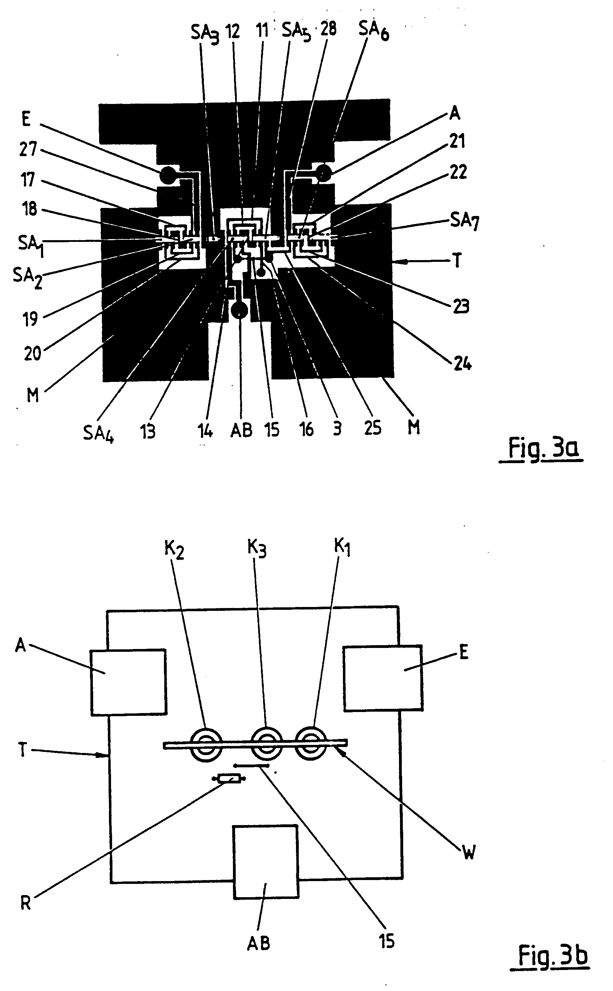

- Figur 3: Ansichten der beiden Seiten der zugehörigen Trägerplatine

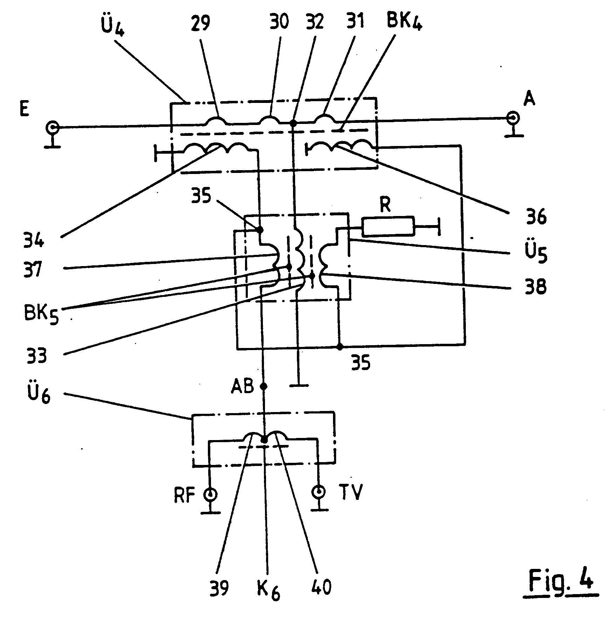

- Figur 4: ein Prinzipschaltbild des zweiten Richtkoppler-Abzweigers und

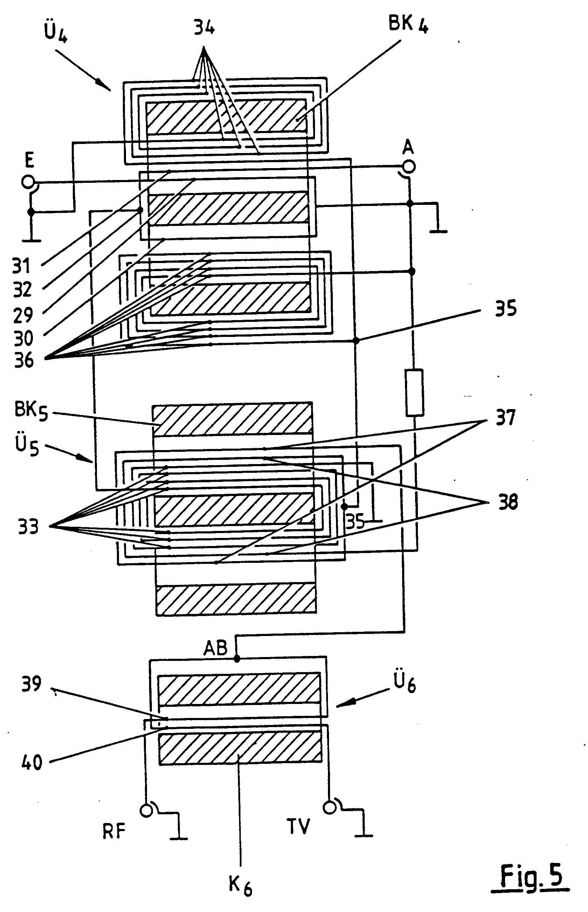

- Figur 5: ein weiteres Prinzipschaltbild, aus dem das zugehörige Wicklungsschema der Übertrager des zweiten Richtkoppler-Abzweigers ersichtlich ist.

Der erste, einen Eingang E, einen Ausgang A und einen Abzweig AB aufweisende Richtkoppler-Abzweiger nach den Fig. 1 bis 3 besteht aus zwei in Kette geschalteten 13-dB-Richtkoppler-Einzelabzweigern, wobei der vom Eingang E her gesehen erste den Eingangswiderstand herauf- und der zweite die Impedanz herabsetzt (gemäß Figuren 3 und 1 der DE-C-3028683, wobei selbstverständlich für den genannten Zweck auch die in den Figuren 2 und 4 dieser Druckschrift dargestellten dualen Typen von Richtkoppler-Einzelabzweigern verwendet werden können). Die beiden zwischen dem Eingang E und dem Ausgang A (Stammleitung) in Reihe geschalteten, getrennte Rohrkern K₁, K₂ aufweisenden Stromübertrager Ü₁, Ü₂, bei denen die Primärwicklung 4,5 jeweils nur aus einem durch den jeweiligen Rohrkerns K₁, K₂ geführten Leiter (halbe Windung) besteht, koppeln in ihre einseitig an Masse liegenden Sekundärspulen 6,7 gleichphasige Ströme aus. Die beiden Spannungsübertrager sind durch eine gemeinsame Primärwicklung 8 zu einem Spannungsübertrager Ü₃ mit nur einem Kern K₃ zusammengefaßt. Die Primärwicklung des Spannungsübertragers Ü₃ ist einerseits am Verbindungspunkt 1 der Primärwicklungen 4, 5 der Stromübertrager Ü₁, Ü₂ und zum anderen an Masse angeschlossen. Die beiden jeweils nur aus einer halben Windung bestehenden Sekundärwicklungen 9, 10 des Spannungsübertragers Ü₃ durchsetzen den Kern K₃ gegensinnig und sind am Punkt 2 bzw. 3 jeweils am einen Anschluß sowohl miteinander als auch mit der Sekundärwicklung 6, 7 des zugehörigen Stromübertragers Ü₁, Ü₂ verbunden. Der andere Anschluß dieser Sekundärwicklungen 9, 10 ist beim ersten Richtkoppler-Einzelabzweiger direkt zum Abzweiganschluß AB und beim zweiten Richtkoppler-Einzelabzweiger über einen ohmschen Widerstand R - dessen internem Abschlußwiderstand-an Masse geführt.

Die auf der Wicklungsplatine W angeordneten Windungsteile der Primärwicklung 8 des Spannungsübertragers Ü₃ sind durch Leiterbahnen 11, 12, 13 auf der kaschierten Seite der Trägerplatine T miteinander verbunden, die Wicklungsteile der Sekundärwicklung 6 des ersten Stromübertragers Ü₁ durch korrespondierende Leiterbahnen 21 bis 24, die Windungsteile der Sekundärwicklung 7 des zweiten Stromübertragers Ü₂ durch entsprechende Leiterbahnen 17 - 20, die Sekundärwicklung 9 des Spannungsübertragers Ü₃ mit dem Abzweiganschluß AB durch eine Leiterbahn 14, die Sekundärwicklung 10 des Spannungsübertragers 3 mit dem internen Abschlußwiderstand R durch eine Leiterbahn 16, die Schaltungspunkte 2 und 3 durch eine Leiterbahn 26, der Eingang E mit der Primärwicklung 4 des ersten Stromübertragers Ü₁ über eine Leiterbahn 27 und der Ausgang A mit der Primärwicklung 5 des zweiten Stromübertragers Ü₂ durch eine Leiterbahn 28. Bis auf eine Drahtbrücke 15 zwischen dem Schaltungspunkt 3 und der Sekundärwicklung 10 des Spannungsübertragers Ü₃ sind dabei sämtliche Verbindungen kreuzungsfrei und somit kostengünstig fertigungstechnisch einfach sowie elektrisch sicher angeordnet.

Die Wicklungsplatine W weist insgesamt 7 Schenkel S₁ bis S₇ auf, die in angepaßte Steckausnehmungen SA₁ bis SA₇ von der unkaschierten Seite her in die Trägerplatine T eingesteckt und deren Leiterbahnen mit den zugehörigen Leiterbahnen der Trägerplatine T auf deren kaschierter Seite durch Tauchlötung verbunden sind.

Aufgrund des beschriebenen, durch exakte Reproduzierbarkeit für die Massenfertigung geeigneten Schaltungsaufbau, bei dem nicht nur die Abzweiganschlüsse der beiden Richtkoppler-Einzelabzweiger zusammengeschaltet sind, sondern der zweite (vorfolgende) Einzelabzweiger den internen Abschlußwiderstand des ersten darstellt, weist der Richtkoppler-Abzweiger insgesamt breitbandig von 40 bis 860 MHz und weitgehend unabhängig von Fehlanpassungen von an ihn anzuschließenden passiven und/oder aktiven Geräten eine Abzweigdämpfung von konstant nur noch etwa 8 dB bei einer Koppeldämpfung zwischen dem Ausgang A und dem Abzweiganschluß AB von ≧ 40 dB, einer Durchgangsdämpfung von ≦ 1,5 dB und einer Rückflußdämpfung an allen Anschlüssen von ≧ etwa 26 dB auf. Er ist damit hervorragend für Kaskadierung und zum Aufbau größerer Verteilnetze geeignet, bei denen er zum Ende der Stammleitung hin die größere Stammdämpfung durch die geringere Abzweigdämpfung ausgleichen kann.
Selbstverständlich könnte dieser Richtkoppler-Abzweiger auch in einem Mehrfachverteiler eingesetzt werden, wobei zum Beispiel die Anschlußdämpfung bei einem 12-fach-Verteiler um ca. 5 dB auf etwa 17 dB verringert werden kann.

Beim zweiten Ausführungsbeispiel nach Fig. 4 und 5 sind wiederum ein auf- und ein abwärtstransformierender Richtkoppler-Einzelabzweiger zu einem Richtkoppler-Abzweiger zusammengeschaltet, der jedoch durch entsprechende Bemessung und Anordnung der Übertragerwicklungen eine Abzweigdämpfung von nur ca. 5 dB aufweist und bei dem die beiden Stromübertrager zu einem einzigen Übertrager Ü₄ zusammengefaßt und dieser Stromübertrager Ü₄ sowie der Spannungsübertrager Ü₅ auf zwei Bilochkernen BK₄, BK₅ gewickelt sind. Dem Abzweiganschluß AB, der durch das entsprechend gewählte Windungszahlenverhältnis des Spannungsübertragers Ü₅ eine Impedanz von Z_{L}/2 aufweist, ist ein Differential-Rohrkernübertrager Ü₆ nachgeschaltet, dessen beide durch die im Rohrkern K₆ gegensinnig verlaufenden Ströme hochentkoppelten, für den Anschluß eines Rundfunk-und eines Fernseh-Empfängers vorgesehenen breitbandigen Ausgänge RF und TV eine geringe Anschlußdämpfung von insgesamt jeweils etwa 8 dB aufweisen.
Die den Eingang E und den Ausgang A verbindenden beiden Primärwicklungen 29 und 30, 31 des Stromübertragers Ü₄ sind direkt aufeinanderfolgend, also ohne eine störende Streuinduktivität durch Rückführung außerhalb des Kerns BK₄ zu verursachen, durch dessen beide Bohrungen, an seinem Mittelschenkel anliegend geführt. Die erste Primärwicklung 29 besteht dabei aus einer halben Windung , die zweite Primärwicklung 30,31 aus zwei halben Windungen. Am Verbindungspunkt 32 der beiden halben Windungen 30,31 ist das eine Ende der aus sieben Halbwindungen bestehenden gemeinsamen Primärwicklung 33 des Spannungsübertragers Ü₅ angeschlossen, deren anderes Ende an Masse liegt.
Die erste, auf einem Außenschenkel des Bilochkerns BK₄ enggewickelte Sekundärwicklung 34 des Stromübertragers Ü₄ liegt einerseits an Masse und zum anderen über den Schaltungspunkt 35 sowohl an der zweiten, auf dem anderen Außenschenkel des Bilochkerns BK₄ eng gewickelten Sekundärwicklung 36 des Stromübertragers Ü₄, als auch an der ersten, zum Abzweiganschluß AB führenden Sekundärwicklung 37 und der zweiten, zum internen Abschlußwiderstand R des zweiten Richtkoppler-Einzelabzweigers führenden Sekundärwicklung 38 des Spannungsübertragers Ü₅. Alle Wicklungen 33,37,38 des Spannungsübertragers Ü₅ sind auf dem Mittelschenkel des Bilochkernes BK₅ gewickelt, die Sekundärwicklungen 37,38 zur besseren Entkopplung gegensinnig. Dabei weisen die Wicklungen des Spannungsübertragers Ü₅ den doppelten Wert des Kopplungsfaktors der Wicklungen des Stromübertragers Ü₄ auf.

Der dem Abzweiganschluß AB nachgeschaltete Differentialübertrager Ü₆ verteilt die mit etwa 5 dB gedämpfte Signalenergie breitbandig über die den Rohrkern K₆ gegensinnig durchsetzenden Leitungen 39,40 mit einer Verteildämpfung von etwa 3 dB, so daß die beiden durch das Differentialübertragerprinzip hochentkoppelten Anschlüsse RF, TV jeweils ca. 8 dB Anschlußdämpfung aufweisen und die Antennensteckdose daher ebenfalls am Ende langer Stammleitungen einsetzbar ist. Auch hier sind die bereits beim ersten Ausführungsbeispiel genannten sehr guten elektrischen Daten und damit die Vorteile einer guten Kaskadierbarkeit und der Erfüllung der in der Vorschrift 1 R8-15 geforderten Werte erreicht. Die Bewicklung der kleinen Bilochkerne von Hand ist zwar etwas teuerer als der Aufbau in Drucktechnik gemäß dem ersten Ausführungsbeispiel, im Hinblick auf die dort erforderlichen relativ hohen Werkzeugkosten ist dieser Aufbau jedoch für Kleinserien sinnvoll.

## Patentansprüche

1. Richtkoppler-Abzweiger für Gemeinschaftsantennen- oder BK-Anlagen, zum breitbandigen Auskoppeln eines Teils der über eine Stammleitung übertragenen Hochfrequenz-Signalenergie, bestehend aus wenigstens zwei in Kette geschalteten Einzelabzweigern, von denen wenigstens einer in Richtkopplertechnik mit einem Strom- Rohrkernübertrager (Ü₁,Ü₂,Ü₄) und einem Spannungs-Rohrkernübertrager (Ü₃,Ü₅) sowie einem einseitig an Masse liegenden internen Abschlußwiderstand (R) aufgebaut ist,
dadurch gekennzeichnet, daß der interne Abschlußwiderstand jedes Richtkoppler-Einzelabzweigers mittels Verbindung seines Abzweiganschlusses (2,35) mit dem Abzweiganschluß (3,35) des unmittelbar vorfolgenden Einzelabzweigers durch dessen Abzweigimpedanz gebildet ist, daß der Abzweig des letzten Richtkoppler-Einzelabzweigers der einzige Abzweiganschluß (AB) ist, und daß die Schaltung derart angelegt ist, daß alle aus den Stromübertragern (Ü₁,Ü₂,Ü₄) ausgekoppelten Ströme zumindest annähernd phasengleich sind.

2. Richtkoppler-Abzweiger nach Anspruch 1, dadurch gekennzeichnet, daß der erste Einzelabzweiger ebenfalls ein Richtkoppler-Einzelabzweiger mit einem ohmschen Widerstand (R) als internem Abschlußwiderstand ist.

3. Richtkoppler-Abzweiger nach Anspruch 1, dadurch gekennzeichnet, daß der erste Einzelabzweiger ein Widerstandsabzweiger mit einem ohmschen Widerstand zwischen Eingang und Abzweiganschluß oder mit je einem ohmschen Widerstand zwischen Eingang und Abzweiganschluß sowie diesem und Masse ist.

4. Richtkoppler-Abzweiger nach einem der Ansprüche 1 bis 3, dadurch gekennzeichnet, daß die Einzelabzweiger derart ausgebildet sind, daß sie, in alternierender Reihenfolge zusammengeschaltet, nacheinander die jeweilige Eingangsimpedanz herab- bzw. herauftransformieren oder umgekehrt.

5. Richtkoppler-Abzweiger nach einem der Ansprüche 1 bis 4 dadurch gekennzeichnet, daß für die Spannungsübertrager (Ü₃,Ü₅) wenigstens zweier Richtkoppler-Einzelabzweiger lediglich eine einzige Primärwicklung (8,33) vorgesehen ist.

6. Richtkoppler-Abzweiger nach Anspruch 5, dadurch gekennzeichnet, daß jeweils zwei Sekundärwicklungen (9,10,37,38) des Spannungsübertragers (Ü₃,Ü₅) von ihrem Zusammenschaltpunkt (2,3,35) aus wenigstens mit einem Teil ihrer Windungen den Rohrkern (K₃,BK₅) gegensinnig durchsetzen.

7. Richtkoppler-Abzweiger nach Anspruch 5 oder 6, dadurch gekennzeichnet, daß der Koppelfaktor der Wicklungen des Spannungsübertragers (Ü₃,Ü₅) den n-fachen Wert des Koppelfaktors der n gleichen Stromübertrager-Wicklungen aufweisen.

8. Richtkoppler-Abzweiger nach einem der Ansprüche 1 bis 7, dadurch gekennzeichnet, daß für jeweils zwei zusammengeschaltete Einzelabzweiger ein erster Bilochkern (BK₄) für die beiden in Serie geschalteten Stromübertrager (Ü₄) und ein zweiter Bilochkern (BK₅) für die beiden Spannungsübertrager (Ü₅) vorgesehen sind, daß die Primärwicklungen (29,30,31) der Stromübertrager (Ü₄) ohne Rückführung außerhalb des ersten Bilochkerns (BK₄) direkt aufeinanderfolgend dessen beide Bohrungen am Mittelschenkel anliegend durchsetzen und die Sekundärwicklungen (34,36) der Stromübertrager (Ü₄) auf den beiden äußeren Schenkeln des ersten Bilochkerns (BK₄) angeordnet sind, und daß die Primär- und Sekundärwicklungen (33,37,38) der Spannungsübertrager (Ü₅) auf dem Mittelschenkel des zweiten Bilochkerns (BK₅) angeordnet sind.

9. Richtkoppler-Abzweiger nach einem der Ansprüche 5 bis 8, dadurch gekennzeichnet, daß das Windungszahlenverhältnis der Sekundärwicklungen (37,38) des Spannungsübertragers (Ü₅) und damit die Impedanz des Abzweiganschlusses (AB) derart gewählt ist, daß die Impedanz der Anschlüsse (RF, TV) eines nachgeschalteten, symmetrisch oder asymmetrisch verteilenden Übertragers (Ü₆) mit einen Rohrkern (K₆) gegensinnig durchsetzenden Leitungen (39,40) gleich dem Wellenwiderstand (Z_{L}) ist.

## Claims

1. Direction coupler-distributor for community aerial facilities or BK equipment for broad band decoupling of a part of the high-frequency signal energy transmitted over a principal line, consisting of at least two individual bifurcating distributors connected as a chain, at least one of which being constructed in direction coupler technology with a pipe-core current transmitter (Ü₁, Ü₂, Ü₄) and a pipe-core voltage transmitter (Ü₃, Ü₅) as well as an internal termination resistance (R) being connected to ground on one side,
in such a way characterised, that the internal termination resistance of each individual direction coupler-distributor results from the distribution impedance of the connection of its bifurcating connection point (2, 35) with the bifurcating connection point (3, 35) of the individual direction coupler-distributor immediately preceding it; that the bifurcating point of the last individual direction coupler-distributor is the only bifurcating connection point (AB); and that the circuitry is designed in such a way that all partial currents decoupled from the current transmitters (Ü₁, Ü₂, Ü₄) are at least approximately inphase.

2. Direction coupler-distributor according to claim 1, in such a way characterised, that the first individual bifurcating distributor is also an individual direction coupler-distributor with an ohmic resistance (R) as internal termination resistance.

3. Direction coupler-distributor according to claim 1, in such a way characterised, that the first individual bifurcating distributor is a resistance distributor with an ohmic resistance between input and bifurcating point or with one ohmic resistance each between input and bifurcating point as well as this point and ground.

4. Direction coupler-distributor according to one of the claims 1 to 3, in such a way characterised, that the individual bifurcating distributors are designed in such a way that they being connected in series in alternating order, transform the respective input impedance downward or upward and vice versa.

5. Direction coupler-distributor according to one of the claims 1 to 4, in such a way characterised, that for the voltage transmitters (Ü₃, Ü₅) of at least two individual direction coupler-distributors only one single primary winding (8, 33) is provided.

6. Direction coupler-distributor according to claim 5, in such a way characterised, that for every two secondary windings (9, 10, 37, 38) of the voltage transmitter (Ü₃, Ü₅) from their interconnection point (2, 3, 35) onward, at least part of their respective windings penetrate the pipe-core (K₃, BK₅) in opposite direction.

7. Direction coupler-distributor according to claim 5 or 6, in such a way characterised, that the coupling factor of the windings of the voltage transmitter (Ü₃, Ü₅) has the n-fold value of the coupling factor of the n equal current transmitter windings.

8. Direction coupler-distributor according to one of the claims 1 to 7, in such a way characterised, that for every two interconnected individual bifurcating distributors a first two-hole core (BK₄) for the two current transmitters (Ü₄) connected in series and a second two-hole core (BK₅) for the two voltage transmitters (Ü₅) are provided, that the primary windings (29, 30, 31) of the current transmitters (Ü₄) penetrate the two holes of the first two-hole core (BK₄) outside of this first two-hole core immediately following each other without return connection and tightly lying at its middle part, that the secondary windings (34, 36) of the current transmitters (Ü₄) are placed on the two outer parts of the first two-hole core (BK₄), and that the primary and secondary windings (33, 37, 38) of the voltage transmitters (Ü₅) are placed on the middle part of the second two-hole core (BK₅).

9. Direction coupler-distributor according to one of the claims 5 to 8, in such a way characterised, that the ratio of the winding numbers of the secondary windings (37, 38) of the voltage transmitter (Ü₅) and thus the impedance of the bifurcating connection point (AB) is chosen in such a way that the impedance of the connection points (RF, TV) of a subsequently connected symmetrically or asymmetrically bifurcating transmitter (Ü₆) with its leads (39, 40) penetrating a pipe-core (K₆) in opposite direction, is equal to the iterative resistance (Z_{L}).

## Revendications

1. Coupleur directionnel-distributeur pour des réseaux individuels et communs d'antennes pour découpler à large bande un part du signal à énergie haute fréquence qui est transmet sur une ligne principale, qui se compose aux moins de deux distributeurs individuels connectés comme chaîne dont aux moins un est construit en technologie accoupleur directive avec un translateur de courant avec noyau tubulaire (Ü₁, Ü₂, Ü₄) et un translateur de tension avec noyau tubulaire (Ü₃, Ü₅) et une résistance terminale (R) interne,
caractérisé par les faits que la résistance terminale interne de chaque coupleur directionnel-distributeur individuel est le résultat de l'impédance de distribution de la connexion du point de branchement (2, 35) de ce coupleur directionnel-distributeur individuel avec le point de branchement (3, 35) du coupleur directionnel-distributeur individuel qui lui précède immédiatement; que le point de branchement du dernier coupleur directionnel-distributeur individuel est le seul point de connexion de branchement (AB); et que les circuits sont construit ainsi que tous les courants partiels qui sont découplés hors des translateurs de courant (Ü₁, Ü₂, Ü₄) sont aux moins approximativement en phase.

2. Coupleur directionnel-distributeur comme en revendication 1, caractérisé par les faits que le premier coupleur directionnel-distributeur individuel est un coupleur directionnel-distributeur individuel avec une résistance ohmique (R) comme résistance terminale interne.

3. Coupleur directionnel-distributeur comme en revendication 1, caractérisé par les faits que le premier coupleur directionnel-distributeur individuel est un distributeur à résistance distributor avec une résistance ohmique entre l'entrée et le point de branchement ou avec une résistance ohmique chaque entre l'entrée et le point de branchement et entre ce point et terre.

4. Coupleur directionnel-distributeur selon une des revendications 1 à 3, caractérisé par les faits que les coupleurs directionnels-distributeurs individuels sont construit ainsi que connectés en série en ordre alternante, ils transforment l'impédance d'entrée vers le haut ou vers le bas et vice versa.

5. Coupleur directionnel-distributeur selon une des revendications 1 à 4, caractérisé par les faits que les translateurs de tension (Ü₃, Ü₅) d'au moins deux coupleurs directionnels-distributeurs individuels n'ont plus que un seul enroulement du circuit primaire (8, 33).

6. Coupleur directionnel-distributeur comme en revendication 5, caractérisé par les faits que pour tous les deux enroulements secondaires (9, 10, 37, 38) du translateur de tension (Ü₃, Ü₅) dés leur point d'interconnexion (2, 3, 35) aux moins part de leurs enroulements pénètrent le noyau tubulaire (K₃, BK₅) en direction opposite.

7. Coupleur directionnel-distributeur comme en revendication 5 ou 6, caractérisé par les faits que le facteur de couplage des enroulements du translateur de tension (Ü₃, Ü₅) a une valeur de n-fois du facteur de couplage de n enroulements du translateur de courant équivalents.

8. Coupleur directionnel-distributeur selon une des revendications 1 à 7, caractérisé par les faits qu'il y a pour chaque deux coupleurs directionnels-distributeurs individuels interconnectés un premier noyau à deux trous (BK₄) pour les deux translateurs de courant (Ü₄) connectés en série et un second noyau à deux trous (BK₅) pour les deux translateur de tension (Ü₅), que les enroulements primaires (29, 30, 31) des translateurs de courant (Ü₄) pénètrent les deux trous du premier noyau à deux trous (BK₄) au part central à la côté extérieur de ce premier noyau à deux trous consécutivement sans connexion de retour, que les enroulements secondaires (34, 36) des translateurs de courant (Ü₄) sont situés sur les deux parts extérieures du premier noyau à deux trous (BK₄), et que les enroulements primaires et secondaires (33, 37, 38) des translateurs de tension (Ü₅) sont situés sur le part central du second noyau à deux trous (BK₅).

9. Coupleur directionnel-distributeur selon une des revendications 5 à 8, caractérisé par les faits que rapport des nombres des spires des enroulements secondaires (37, 38) du translateur de tension (Ü₅) et en conséquence l'impédance du point de connexion de branchement (AB) est choisi ainsi que l'impédance des points de connexion (RF, TV) d'un translateur branchant symétrique ou asymétrique qui est connecté en arrière (Ü₆), ses enroulements (39, 40) pénètrent un noyau tubulaire (K₆) en direction opposite, est la même que la résistance itérative (Z_{L}).
